# EUROPEAN PATENT APPLICATION

(11) **EP 2 884 830 A1**
(43) Date of publication of application: **17.06.2015**
(21) Application number: 13838747.7
(22) Date of filing: 17.07.2013
(51) Int. Cl.: H05K 7/20

(54) **MOUNTING DEVICE FOR AN APPARATUS HAVING HEAT DISSIPATION REQUIREMENT**

(30) Priority: 20.09.2012 CN 201210352409
(71) Applicant: Schneider Toshiba Inverter Europe SAS, 27120 Pacy sur Eure (FR)
(72) Inventor: CAI, Yuanjia, Pudong Shanghai 201203 (CN); HU, Liangguo, Shanghai 201203 (CN); YAO, Yingzi, Shanghai 201203 (CN)
(74) Representative: Manitz, Finsterwald & Partner GbR
(86) International application number: PCT/CN2013/079525
(87) International publication number: WO 2014/044079

(57) **Abstract**

A mounting device for an apparatus having a heat dissipation requirement; the apparatus is housed in a cabinet, and comprises a heat dissipation part; the mounting device comprises a box body (1) housed in the cabinet (4); the box body (1) comprises a peripheral wall (11) on the sides, and a first mounting surface and a second mounting surface respectively located at the ends of the peripheral wall (11) on the sides; the first mounting surface and the second mounting surface are oppositely disposed and form an opening in the rear wall of the cabinet; the first mounting surface is mounted around the opening inside the cabinet, and is provided with an opening corresponding to the opening thereon; the apparatus is mounted on the second mounting surface; the heat dissipation part pushes through the second mounting surface, and extends into the box body (1) but does not go beyond the first mounting surface. The apparatus is completely housed in the cabinet, and no heat dissipation part extends outside the cabinet, thus the cabinet can be properly placed against the wall.

## Description

### BACKGROUND

The present invention relates to the field of mounting device facilitating the heat dissipation of an apparatus, and in particular to the mounting device for an apparatus having heat dissipation requirement.

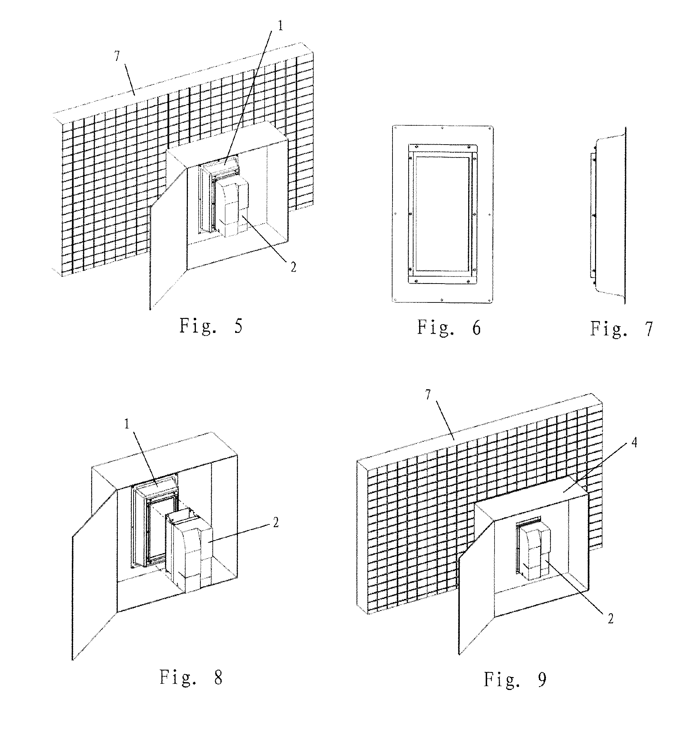

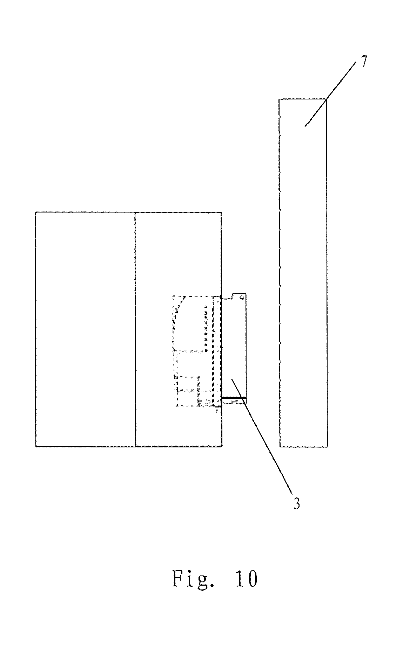

When mounting an apparatus having heat dissipation requirement in prior art, in particular when mounting a frequency converter, push through is one assembly manner extensively used, in which the heat dissipation part of the frequency converter is pushed through the cabinet so as to contact the heat dissipation part with the air outside of the cabinet. As such, it's possible for the heat dissipation part of the frequency converter to release much more heat by contacting the outer air. See Figs. 9 and 10. The push-through mounting device for the frequency converter in prior art is embodied in such a way that a part of the frequency converter 2 protrudes from the cabinet 4 and goes beyond the surface of the cabinet 4, such a part protruding from the cabinet 4 acts as the heat dissipation part 3 of the frequency converter. As a result, when the cabinet 4 provided with the frequency converter 2 is placed against the wall 7, the cabinet 4 can not be placed completely close up to the wall 7 due to the existence of the heat dissipation part 3 of the frequency converter protruding from the cabinet 4, which could waste the space of the room for mounting the cabinet, and the cabinet also has an unattractive appearance and unsatisfactory dust-proof effect.

Accordingly, it is necessary to propose a new mounting device for the apparatus having heat dissipation requirement, which could satisfy the heat dissipation requirement of the prior push-through mounting device and at the same time, also could allow for the apparatus having heat dissipation requirement being entirely housed within the cabinet, in this way, when the cabinet is placed in the room, the cabinet can abut against the wall finely, no wastage of the space occurs, and favorable dust-proof effect could be achieved.

### SUMMARY

The present invention proposes a mounting device for the apparatus having heat dissipation requirement, which enables the apparatus having heat dissipation requirement be wholly housed within the cabinet, and ensures good heat dissipation for the apparatus having heat dissipation requirement.

The technical solution of the mounting device for an apparatus having heat dissipation requirement according to present invention is :A mounting device for an apparatus having heat dissipation requirement, the apparatus is housed in a cabinet, and comprises a heat dissipation part, wherein: the mounting device comprises a box body housed in the cabinet, the box body comprises a peripheral wall on the sides, and a first mounting surface and a second mounting surface respectively located at the ends of the peripheral wall on the sides, the first mounting surface and the second mounting surface are oppositely disposed, an opening is forming in the rear wall of the cabinet, the first mounting surface is mounted around the opening inside the cabinet, and is provided with an opening corresponding to the opening, the apparatus is mounted on the second mounting surface, the heat dissipation part pushes through the second mounting surface, and extends into the box body but does not go beyond the first mounting surface.

With the mounting device for an apparatus having heat dissipation requirement according to the present invention, the box body housing the heat dissipation part of the apparatus having heat dissipation requirement is arranged within the cabinet, thus it's possible to completely house the apparatus having heat dissipation requirement in the cabinet, and the cabinet is provided with an opening, the first mounting surface of the box body is mounted around the opening and provided with correspondent opening, so that the heat dissipation part housed in the box body contacts air outside of the cabinet through the two openings corresponding to each other, thereby the heat produced during the operation of the apparatus having heat dissipation requirement may be effectively dissipated. At the same time, the apparatus having heat dissipation requirement is wholly housed in the cabinet, the heat dissipation part does not go beyond the first mounting surface of the box body, i.e., does not go beyond the cabinet, accordingly, no heat dissipation part protrudes outwards from the cabinet and thus the cabinet may be placed against the wall finely. Such a box body allows for simpler manufacturing technology, lower manufacturing cost, and the mounting device is easy to be assembled.

Preferably, it's further provided with a flange by which the apparatus having heat dissipation requirement and the second mounting surface are coupled therebetween.

With the flange, the apparatus having heat dissipation requirement is mounted onto the second mounting surface of the box body, in such a way that the linkage structure between the apparatus having heat dissipation requirement and the second mounting surface of the box body is simpler and easier to be achieved, thereby finely applying to the existing apparatus having heat dissipation requirement, without any necessity to modify the structure of the existing apparatus having heat dissipation requirement.

Preferably, a sealing device is provided between the first mounting surface and the cabinet.

Preferably, a sealing device is provided between the second mounting surface and the flange.

Preferably, the sealing device is a waterproof sponges or a sealing gasket.

By arranging sealing devices between the first mounting surface and the cabinet as well as between the second mounting surface and the flange respectively, it's possible to effectively strengthen the seal-ability of the cabinet to the outside, providing favorable dust-proof and waterproof effects.

Preferably, the box body is hexahedron-shaped; the peripheral wall on the sides is composed of four sidewalls, each of which is trapezoid or rectangular.

Preferably, the box body is shaped like a cylindrical body; the peripheral wall on the sides is a circumferential wall.

Preferably, the first mounting surface and the second mounting surface are composed respectively of the first edge and the second edge surrounding the two opposite ends of the peripheral wall on the sides.

The first edge and the second edge are used to joint the cabinet and the flange respectively, such a configuration facilitates the mounting of the box body onto the cabinet and also facilitates the fixation of the apparatus having heat dissipation requirement onto the box body, and is simpler.

Preferably, the apparatus having heat dissipation requirement is a frequency converter.

Generally speaking, the mounting device for the apparatus having heat dissipation requirement according to the present invention enables the apparatus having heat dissipation requirement be completely housed within the cabinet and also enables the heat dissipation part of the apparatus having heat dissipation requirement contact the air outside of the cabinet, reaching the purpose of heat dissipation of the apparatus having heat dissipation requirement, and when the cabinet is placed indoors, the cabinet could finely abut against the wall, no wastage of the space occurs, and favorable dust-proof effect could be achieved.

### BRIEF DESCRIPTION OF THE DRAWINGS

Further advantages and characteristics of the present invention will become even more apparent from the following specific embodiments of the present invention given only by way of non-limiting examples and illustrated in the drawings, in which:
Fig.1 is a front view of a cabinet using the mounting device for a frequency converter of the present invention;
Fig.2 is a rear view of a cabinet using the mounting device for a frequency converter of the present invention;
Fig.3 is a schematic view showing the cabinet using the mounting device for a frequency converter of the present invention when abutting against the wall;
Fig.4 is a schematic view showing the box body, the waterproof sponges and flange prior the assembling;
Fig.5 is a schematic view showing the cabinet using the mounting device for a frequency converter of the present invention when being mounted onto the wall;
Fig.6 is a front view of the box body according to the present invention;
Fig.7 is a side view of the box body according to the present invention;
Fig.8 is a schematic view showing the frequency converter according to the present invention when being mounted into the box body;
Fig.9 is a schematic view showing the cabinet using the mounting device for a frequency converter in prior art when being mounted onto the wall;
Fig.10 is a schematic view showing the cabinet using the mounting device for a frequency converter in prior art when abutting against the wall.

### Reference Numerals:

- 1: a box body
- 2: a frequency converter
- 3: heat dissipation part of the frequency converter
- 4: a cabinet
- 5: waterproof sponges
- 6: a flange
- 7: a wall
- 8: a cabinet wall
- 9: a first edge
- 10: a second edge
- 11: a peripheral wall on the sides
- 12: an opening

### DETAILED DESCRIPTION

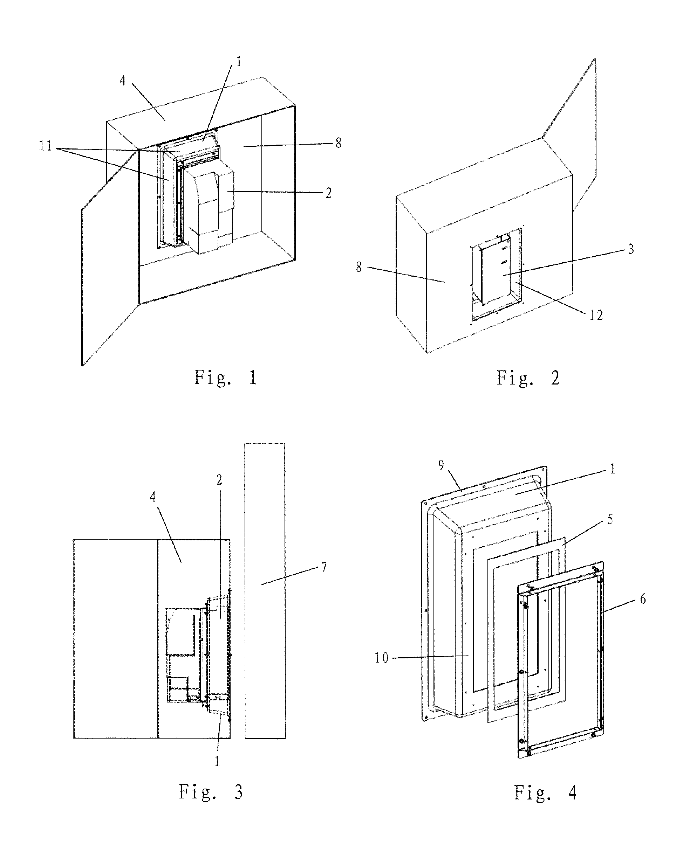

A detailed description will be made to the mounting device for a frequency converter of the present invention in conjunction with Figs. 1 to 8.

The apparatus having heat dissipation requirement described in this embodiment is a frequency converter. Although in this embodiment, the mounting device for an apparatus having heat dissipation requirement according to the present invention is explained only taking the frequency converter as an example, it's to be understood that such a mounting device may be used for not only the frequency converter, but also all the apparatus comprising a heat dissipation part and demanding heat dissipation from the apparatus per se to the outside. The apparatus having heat dissipation requirement mentioned herein generally requires to be mounted into a cabinet, and at the same time, the heat dissipation part thereof requires heat exchange with the air outside of the cabinet.

Fig.1 shows a front view of the cabinet using the mounting device for a frequency converter according to the present invention; Fig.2 shows a rear view of the cabinet using the mounting device for the frequency converter according to the present invention.

The mounting device is suitable for the frequency converter 2, which is housed within the cabinet and comprises a heat dissipation part 3.The box body 1 is also housed within the cabinet 4 and is mounted onto the internal side of the cabinet 4, i.e., onto the cabinet wall 8, and protrudes inward of the cabinet 4.The box body 1 comprises a peripheral wall on the sides 11, the first mounting surface and the second mounting surface are located at the two ends of the peripheral wall on the sides 11 respectively, the first mounting surface is opposite to the second mounting surface. An opening 12 is formed onto the rear wall of the cabinet, the first mounting surface is assembled around the opening 12 inside of the cabinet 4, and the first mounting surface is also provided thereon with an opening corresponding to the opening 12, the frequency converter 2 is mounted onto the second mounting surface, the heat dissipation part 3 passes through the second mounting surface into the box body 1, but does not go beyond the first mounting surface.

Due to the box body for housing the heat dissipation part 3 of the frequency converter 2 is provided within the cabinet 4, it's possible to completely house the frequency converter 2 into the cabinet 4, and an opening 12 is provided onto the cabinet 4, the first mounting surface of the box body 1 is mounted around the opening 12 and is also provided with a correspondent opening, so that the heat dissipation part 3 housed within the box body 1 contacts the air outside of the cabinet 4 via the two correspondent openings and thus the heat produced when the frequency converter 2 operates may be dissipated effectively. The heat dissipation part 3 of the frequency converter 2 passes through the second mounting surface and extends into the box body 1, and the heat dissipation part does not go beyond the first mounting surface of the box body, that is, does not go beyond the cabinet 4, hence, no part of the heat dissipation part 3 protrudes outward from the cabinet 4, so that the cabinet 4 may abut against the wall finely. Such a box body 1 allows for simpler manufacturing technology, lower manufacturing cost, and the mounting device is easy to be assembled.

Fig.3 is a schematic view showing the cabinet using the mounting device for the frequency converter according to the present invention when abutting against the wall.

It's clear from Fig.3 that the frequency converter 2 is wholly housed into the cabinet 4, no part of the heat dissipation part 3 protrude outward from the cabinet 4, hence the cabinet 4 may be placed abutting against the wall 7 finely.

Fig.4 is a schematic view showing the box body 1, the waterproof sponges 5 and the flange 6 prior the assembling; Fig.5 is a schematic view showing the cabinet using the mounting device for the frequency converter according to the present invention when being mounted onto the wall.

Figs 4 and 5 clearly shows that the frequency converter 2 and box body 1 connect with each other by means of the flange 6, that is, the frequency converter 2 is securely connected onto the second mounting surface of the box body 1 by the flange 6.By using the flange 6 to securely connect the frequency converter 2 and the second mounting surface of the box body 1 together, the linkage structure between the frequency converter 2 and the box body 1 is simpler, easier to be implemented, and thus may be highly suitable for the existing frequency converters without any necessity to further modify the frequency converter.

The schematic view of Fig. 4 also shows that a waterproof sponges 5 is provided between the box body 1 and flange 6.Waterproof sponges (not shown) is also provided between the box body 1 and the cabinet for the same purpose.

Since waterproof sponges is provided respectively between the box body 1 and the cabinet as well as between the box body 1 and the flange 6, the cabinet may be effectively sealed from the erosion of the dust and liquid outside of the cabinet. Of course, the waterproof sponges may also adopt other sealing materials, for example, rubber gaskets or any sealing gaskets of synthetical resin that may be applied herein.

In this embodiment, the box body is hexahedron-shaped, the peripheral walls on the sides are four sidewalls, and each sidewall along the periphery of the box body 1 is trapezoid. Of course, the box body formation of other shapes is also possible, as long as they can allow for the housing of the heat dissipation part of the frequency converter within the inner portion of the box body, for example, rectangular box body, cylindrical body-shaped box body, or oval-column-shaped box body etc..

In this embodiment, the first mounting surface and the second mounting surface are constituted respectively by the first edge 9 and the second edge 10 surrounding the two opposite ends of the peripheral wall on the sides.

The first edge 9 and the second edge 10 acts respectively as the first mounting surface and the second mounting surface, for jointing the cabinet 4 and the flange 6, such a configuration facilitates the assembling of the box body 1 onto the cabinet 4 and also facilitates the fixation of the frequency converter 2 onto the box body 1, thus creating a simpler configuration.

Of course, the first mounting surface and the second mounting surface may also constituted by the edges, and other forms are also possible, as long as they meet the requirement that the second mounting surface thereof may connect with the frequency converter, the heat dissipation part of the frequency converter may pass through the second mounting surface into the inner portion of the box body, the first mounting surface may connect with the cabinet, and the first mounting surface may allow for the contact of the heat dissipation part of the frequency converter with the air outside of the cabinet. Such a configuration in this embodiment may save the materials for the box body and also the inner space of the cabinet occupied by the box body.

Generally speaking, the mounting device for the frequency converter according to the present invention enables the frequency converter be completely housed within the cabinet and also enables the heat dissipation part of the frequency converter contact the air outside of the cabinet, reaching the purpose of heat dissipation of the frequency converter, and when the cabinet is placed indoors, the cabinet could finely abut against the wall, no wastage of the space occurs, and favorable dust-proof effect could be achieved.

When the mounting device is applied to the apparatus having heat dissipation requirement, the mounting device for the apparatus having heat dissipation requirement according to the present invention enables the apparatus having heat dissipation requirement be completely housed within the cabinet and also enables the heat dissipation part of the apparatus having heat dissipation requirement contact the air outside of the cabinet, reaching the purpose of heat dissipation of the apparatus having heat dissipation requirement, and when the cabinet is placed indoors, the cabinet could finely abut against the wall, no wastage of the space occurs, and favorable dust-proof effect could be achieved.

A detailed introduction is made to the present invention hereinbefore, the variations made by the skilled in this art based on the idea of the embodiment of present invention about particular embodiments and the range of application should not be construed as departing from the protective scope of the present invention, any modification within the protective scope of the claims fall into the protective scope of the present invention, and in general, the content of this specification should not be regarded as limitation to the present invention.

## Claims

1. A mounting device for an apparatus having a heat dissipation requirement, the apparatus is housed in a cabinet (4), and comprises a heat dissipation part (3), **Characterized in that** the mounting device comprises a box body (1) housed in the cabinet (4); the box body (1) comprises a peripheral wall on the sides, and a first mounting surface and a second mounting surface respectively located at the ends of the peripheral wall on the sides, the first mounting surface and the second mounting surface are oppositely disposed, an opening (12) is provided in the rear wall of the cabinet, the first mounting surface is mounted around the opening (12) inside the cabinet (4) and is provided with an opening corresponding to the opening (12), the apparatus is mounted on the second mounting surface, the heat dissipation part (3) passes through the second mounting surface, and extends into the box body (1) but does not go beyond the first mounting surface.

2. The mounting device for an apparatus having heat dissipation requirement according to claim 1, **characterised in that** further comprising a flange (6) by means of which the apparatus and the second mounting surface is connected.

3. The mounting device for an apparatus having heat dissipation requirement according to claim 1, **characterised in that** the apparatus is a frequency converter (2).

4. The mounting device for an apparatus having heat dissipation requirement according to claim 1, **characterised in that** a sealing device is provided between the first mounting surface and the cabinet (4).

5. The mounting device for an apparatus having heat dissipation requirement according to claim 2, **characterised in that** a sealing device is provided between the second mounting surface and the flange (6).

6. The mounting device for an apparatus having heat dissipation requirement according to claim 4 or 5, **characterised in that** the sealing device is waterproof sponge or sealing gasket.

7. The mounting device for an apparatus having heat dissipation requirement according to any one of claims 1 to 5, **characterised in that** the box body (1) is hexahedron-shaped, and the peripheral walls on the sides are four sidewalls, each of which is trapezoid or rectangular.

8. The mounting device for an apparatus having heat dissipation requirement according to any one of claims 1 to 5, **characterised in that** the box body (1) is cylinder-shaped, and the peripheral wall on the sides is a circumferential wall.

9. The mounting device for an apparatus having heat dissipation requirement according to any one of claims 1 to 5, **characterised in that** the first mounting surface and the second mounting surface are respectively composed of the first edge (9) and the second edge (10) surrounding the two opposite ends of the peripheral wall on the sides.
